# EUROPEAN PATENT SPECIFICATION

(11) **EP 2 717 320 B1**
(45) Date of publication and mention of the grant of the patent: **11.09.2019**
(21) Application number: 12793834.8
(22) Date of filing: 09.02.2012
(51) Int. Cl.: H01L 31/0224, H01L 31/18, C03C 17/34, C03C 17/36, H01L 31/0236

(54) **PREPARATION METHOD FOR SURFACE-TEXTURED CONDUCTIVE GLASS AND ITS APPLICATION FOR SOLAR CELLS**
HERSTELLUNGSVERFAHREN FÜR OBERFLÄCHENTEXTURIERTES LEITFÄHIGES GLAS UND DESSEN ANWENDUNG FÜR SOLARZELLEN
PROCÉDÉ DE PRÉPARATION DE VERRE CONDUCTEUR ET TEXTURÉS EN SURFACE ET SON APPLICATION POUR CELLULES SOLAIRES

(30) Priority: 28.05.2011 CN 201110141276
(43) Date of publication of application: 09.04.2014
(73) Proprietor: Huizhou E-Fly Solar Co., Ltd., Huizhou, Guangdong 516006 (CN)
(72) Inventor: WANG, Yang, Huizhou Guangdong 516006 (CN)
(74) Representative: Lösch, Christoph Ludwig Klaus
(86) International application number: PCT/CN2012/070984
(87) International publication number: WO 2012/163101

(56) References cited:
- EP-A1- 1 830 412
- WO-A1-88/09265
- CN-A- 101 582 331
- CN-A- 102 254 961
- JP-A- 2001 007 363
- JP-A- 2003 221 256
- KLUTH O ET AL: "Texture etched ZnO:Al coated glass substrates for silicon based thin film solar cells", THIN SOLID FILMS, ELSEVIER-SEQUOIA S.A. LAUSANNE, CH, vol. 351, no. 1-2, 30 August 1999 (1999-08-30), pages 247-253, XP004183103, ISSN: 0040-6090, DOI: 10.1016/S0040-6090(99)00085-1

## Description

### Technical field

This invention belongs to the technical field of specialty glass production. It is, in detail, related to a preparation method for a surface-textured conductive glass for solar cells.

### Background art

Conductive glass is a special type of glass having one side coated with a transparent conductive film, thus having features of being both transparent and electrically conductive. Besides being applied in LCD and warm-keeping doors and windows, conductive glass also serves as an essential part for solar cells, for it can be used as the transparent electrode and superstrate. The photoelectric quality of the glass directly affects the performance of the solar cells, thus conductive glass is a key material for preparing Amorphous Silicon, Microcrystalline Silicon, Cadmium Telluride, CIGS (Copper Indium Gallium Selenide) thin film solar cells. The issue of how to produce high-quality low-cost surface-textured conductive glass for solar cells is essential to produce low-cost high-efficiency solar cells for cost-effective solar power generation.

Currently, we have the following types of specialty conductive glass used for producing solar cells and their preparation methods:
1) ITO (indium tin oxide) conductive glass made by magnetron sputtering;
2) AZO (aluminum-doped zinc oxide) conductive glass made by magnetron sputtering;
3) FTO (fluorine-doped tin oxide) conductive glass made by Atmospheric Pressure Chemical Vapor Deposition (APCVD);
4) BZO (boron-doped zinc oxide) or AZO (aluminum-doped zinc oxide) conductive glass made by Low Pressure Chemical Vapor Deposition (LPCVD);

To enhance light absorption, the transparent conductive film should have a certain degree of texture, namely unevenness, at nano/micro-scale, so as to enable diffuse scattering (usually measured by haze value) during light incidence and extend optical path for light propagation inside the cell (As shown in Draw. 1).

Among conductive glass samples in lab, we mainly have the following three kinds of surface texture:
1) AZO conductive glass made by hydrochloric acid wet etching after magnetron sputtering (as shown in Draw. 2);
2) FTO conductive glass made by APCVD (as shown in Draw. 3);
3) BZO or AZO conductive glass made by LPCVD (as shown in Draw. 4).

Meanwhile, the surface feature of the transparent conductive film must ensure that the quality of the absorption layer of the solar cell remains free of negative influences from its unevenness. As a cell is usually prepared layer-by-layer in a sequential order, the transparent conductive film serves as the direct substrate on which the absorption layer grows, and its shape directly affects the growth mode and the quality of the absorption layer. Taking microcrystalline silicon absorption layers for instance (as shown in Draw. 5), different surface texture shapes of transparent conductive films have led to microcrystalline silicon absorption layers with different qualities.

When the textured surface of the transparent conductive film takes on a V-shape (Draw. 5A), the microcrystalline silicon absorption layer on top is easy to have fissure, which severely affects the performances of the solar cells. The microcrystalline silicon absorption layer has less fissure (Draw. 5B) or even no fissure (Draw. 5C) when the surface texture takes on a U-shape. Besides, cadmium telluride absorption layers have stricter requirements than microcrystalline silicon absorption layers on surface texture morphology, which requires the surface texture to totally consist of shallower U-shaped pits.

For the above three types of samples, only AZO conductive glass made by hydrochloric acid wet etching after magnetron sputtering and BZO (or AZO) conductive glass made by LPCVD may meet the requirement on U-shaped surface texture morphology. During industrial volume production, however, due to the uneasy control of wet etching, problems like uneven, unstable products and low yield do exist in the former, while the later needs long time of plasma etching, and thus both render too high cost for industrial production. Up to now, it is still a gap in the world to find an industrialized low-cost method to produce U-shaped surface-textured conductive glass for microcrystalline silicon and cadmium telluride thin film solar cells. Due to facts stated above, the production cost for microcrystalline silicon thin film solar cells remains high and the production of cadmium telluride thin film solar cells has only to use planar FTO conductive glass which almost has no surface texture.
Kluth O., et al.: "Texture etched ZnO:Al coated glass substrates for silicon based thin film solar cells", THIN SOLID FILMS, ELSEVIER-SEQUOIA S.A. LAUSANNE, CH, vol. 351, no. 1-2, 30 August 1999, pages 247-253 discloses a preparation method for a surface-textured conductive glass for solar cells. At first, a transparent conductive film is coated on a glass substrate by magneton sputtering. The texturing of the conductive film is achieved by etching.

### Invention Description

To overcome the shortcomings of the existing technologies, this invention mainly aims at providing a low-cost surface-textured conductive glass for solar cells, having a textured surface over which nano-scopic U-shaped pits uniformly distributed.

This invention also aims at providing a preparation method for surface-textured conductive glass for solar cells mentioned above. The preparation method comprises: coating a transparent conductive film (ITO, AZO, etc.) by magnetron sputtering, then absorbing nano/micro-spheres onto the surface of the transparent conductive film as a mask by using an immersion coating method, followed by increasing the thickness of the transparent conductive film in gaps among the nano/micro-spheres (dia. 10 nm-100 µm) by magnetron sputtering, and finally removing the nano/micro-spheres by mechanical or chemical means such as the ultrasonic vibration method, so as to extensively realize the low-cost production of the conductive glass with U-shaped surface texture.

Still, this invention aims at providing the application of surface-textured conductive glass for solar cells mentioned above.

The purposes of this invention can be realized via the following technical solutions.

A surface-textured conductive glass for solar cells, with the following structure and composition: a transparent conductive film coated on a glass substrate, the upper surface of which is a textured surface with nano/micro-scopic U-shaped surface texture.

The thickness of the said transparent conductive film is 100-5,000 nm.

The said transparent conductive film adopts one of the following materials: ITO, AZO or other materials (isoelectric point>3).

The preparation method of said surface-textured conductive glass for solar cells, including the following procedures (as shown in Draw.6):
(1) Conductive glass A is derived after coating the transparent conductive film on a glass substrate by magnetron sputtering.
(2) Prepare the monodispersed nano/micro-sphere suspension and adjust its pH value to 3-7; immerse conductive glass A in the suspension for 2-15 minutes, and then take it out and wash it with water, and then conductive glass B is derived.
   Due to the fact that the transparent conductive films such as ITO and AZO have higher isoelectric points (usually 6-10), and nano/micro-spheres of silicon dioxide or polystyrene have lower isoelectric points (usually 2-4), when the conductive glass is immersed into the neutral (pH=7) or acidic (pH=3-6) suspension containing nano/micro-spheres, the surface of the transparent conductive film carries negative electrical charges while the surface of the nano/micro-spheres carry positive electrical charges, and thus the electrostatic attraction is resulted in between the two materials. After certain time, the surface of the transparent conductive film is almost totally covered by a monolayer of nano/micro-spheres. The area coverage of nano/micro-spheres on conductive glass depends on the concentration and the pH value of the nano/micro-sphere suspension, and the immersion coating time.
(3) Taking nano/micro-spheres as a mask, a transparent conductive film is coated on conductive glass B by magnetron sputtering, and thus conductive glass C is derived. The thickness of the film newly coated should not exceed the radius of the nano/micro-spheres, and the total thickness of the transparent conductive film is 100-5,000 nm.
   The reason for using magnetron sputtering to coat the second film again lies in that the coated materials can, during magnetron sputtering, reach the side positions below the nano/micro-spheres, and form a U-shaped textured surface without sharp edges and corners (as shown in Draw. 7).
(4) Remove the nano/micro-spheres by an ultrasonic vibration method to form a surface texture of U-shaped nano/micro-scopic pits on the surface of conductive glass C, and thus the surface-textured conductive glass for solar cells is derived. The transmittance in the visible spectrum of the conductive glass is more than 80%, and the sheet resistance is less than 10 Ω.

The magnetron sputtering as stated in procedure (1) and (3) has the following conditions: base vacuum pressure: <1×10⁻⁵ Torr; working pressure: 1-10 mTorr; working gas: Ar+O₂; sputtering plasma source: direct current or radio frequency 13.56 MHz; power: 100-1,000 W; substrate temperature: 20-500 °C; deposition rate: 10-100 nm/min.

The diameters of the nano/micro-spheres as stated in procedure (2) are within the range of 10 nm-100 µm.

The material of the nano/micro-spheres as stated in procedure (2) is either silicon dioxide or polystyrene.

The weight/volume (w/v) concentration of nano/micro-spheres in the suspension as stated in procedure (2) is 0.01-1%.

The solvent of the suspension as stated in procedure (2) is water, methanol or ethanol.

The preferable immersion time for the conductive glass in the suspension as stated in procedure (2) is 8-10 minutes.

The surface-textured conductive glass for solar cells stated above can be used as the transparent electrode or superstrate for solar cells.

The said nano/micro-spheres in this invention refer to the nano-scopic spheres or micron-scopic spheres, and the nano/micro refers to nanometer or micrometer.

This invention has the following advantages and effects comparing with the existing technologies:

From the angle of industrial production, the techniques adopted in this method, including planar glass panel magnetron sputtering, immersion coating and cleaning, are all well matched with the presently standard industrial processing techniques. It has the advantages of higher producing efficiency, larger applicable glass area, higher repeatability, and higher yield. Also, the nano/micro-spheres used are of low cost. As a result, this invention is very suitable for producing the low-cost and high-quality conductive glass for solar cells.

### Drawing Description

Draw. 1 is the cross-section structure of an amorphous silicon thin film solar cell.
Draw. 2 is the microstructure of the textured surface in AZO conductive glass prepared by hydrochloric acid wet etching after magnetron sputtering.
Draw. 3 is the microstructure of the textured surface in FTO conductive glass prepared by APCVD.
Draw. 4 is the microstructure of the textured surface in BZO or AZO conductive glass prepared by LPCVD.
Draw. 5 is the comparison of the growth states of microcrystalline silicon on different conductive glass substrates.
Draw. 6 is the schematic flow chart for preparing the surface-textured conductive glass for solar cells in this invention.
Draw. 7 is the sketch map of the film deposition mode when coating films by magnetron sputtering using nano/micro-spheres as a mask.
Draw. 8 is the conductive glass coated with nano/micro-spheres in Embodiment 1.
Draw. 9 is the conductive glass coated with nano/micro-spheres in Embodiment 2.
Draw. 10 is the conductive glass coated with nano/micro-spheres in Embodiment 3.
Draw. 11 is the conductive glass coated with nano/micro-spheres in Embodiment 4.
Draw. 12 is the conductive glass coated with nano/micro-spheres in Embodiment 5.
Draw. 13 is the conductive glass coated with nano/micro-spheres in Embodiment 6.
Draw. 14 is the top view of the surface feature in the conductive glass after removing nano/micro-spheres in Embodiment 1; A - magnification of 10,000, B - magnification of 5,000.
Draw. 15 is the side view at 30° tilt angle of the surface feature in the conductive glass after removing nano/micro-spheres in Embodiment 1; A - magnification of 10,000, B- magnification of 5,000.

### Embodiments

We hereby make more detailed descriptions of this invention in combination with embodiments and drawings, but the embodiments of this invention are not limited to these ones.

### Embodiment 1

A preparation method for surface-textured conductive glass for solar cells, including the following procedures (As shown in Draw. 6):
(1) An AZO transparent conductive film is coated on a glass substrate by magnetron sputtering, and conductive glass A is derived. The conditions for magnetron sputtering are: base vacuum pressure: 0.8×10⁻⁵ Torr; working pressure: 1 mTorr; working gas: Ar+O₂; sputtering plasma source: direct current or radio frequency 13.56 MHz; power: 1,000 W; substrate temperature: 20 °C; deposition rate: 100 nm/min;
(2) Prepare a suspension (0.25% w/v) of polystyrene nano-spheres (dia. 1,000 nm) in water, and adjust its pH value to 4; immerse conductive glass A in the suspension for 2 minutes, and then take it out and wash it with water, and then conductive glass B is derived;
   As shown in Draw. 8, conductive glass B is coated with a monolayer of nano-spheres;
(3) Taking nano-spheres as a mask, an AZO transparent conductive film is coated on conductive glass B by magnetron sputtering (the magnetron sputtering conditions are the same as those in Procedure (1)), and thus conductive glass C is derived. The thickness of the film newly coated should not exceed the radius of nano-spheres, and the total thickness of the transparent conductive film is 2,000 nm;
(4) Remove the nano-spheres deposited on the surface of the transparent conductive film by using an ultrasonic vibration method, and thus the surface-textured conductive glass for solar cells is derived. The surface features of conductive glass after removing nano-spheres are shown in Draw. 14 and Draw. 15. The pits on the textured surface present a smooth curvature and thus an obvious U-shape, and also, these pits are uniformly distributed over the surface of the conductive glass. The transmittance in the visible spectrum of the conductive glass is 82%, and surface resistance is 3 Ω. This conductive glass can be used as the transparent electrode or superstrate for solar cells.

### Embodiment 2

A preparation method for surface-textured conductive glass for solar cells, including the following procedures (As shown in Draw. 6):
(1) An AZO transparent conductive film is coated on a glass substrate by magnetron sputtering, and conductive glass A is derived. The conditions for magnetron sputtering are: base vacuum pressure: 0.7×10⁻⁵ Torr; working pressure: 10 mTorr; working gas: Ar+O₂; sputtering plasma source: direct current or radio frequency 13.56 MHz; power: 100 W; substrate temperature: 500 °C; deposition rate: 100 nm/min;
(2) Prepare a suspension (0.5% w/v) of silicon dioxide nano-spheres (dia. 1,000 nm) in ethanol, and adjust its pH value to 7; immerse conductive glass A in the suspension for 4 minutes, and then take it out and wash it with water, and then conductive glass B is derived;
   As shown in Draw. 9, conductive glass B is coated with a monolayer of nano-spheres;
(3) Taking nano/micro-spheres as a mask, an AZO transparent conductive film is coated on conductive glass B by magnetron sputtering (the magnetron sputtering conditions are the same as those in Procedure (1)), and thus conductive glass C is derived. The thickness of the film newly coated should not exceed the radius of the nano/micro-sphere, and the total thickness of the transparent conductive film is 3,000 nm;
(4) Remove the nano/micro-spheres deposited on the surface of the transparent conductive film by an ultrasonic vibration method, so as to form the surface texture consisting of U-shaped nano/micro-scopic pits on the surface of conductive glass C, and thus the surface-textured conductive glass for solar cells is derived. The transmittance in the visible spectrum of the conductive glass is 83%, and the sheet resistance is 4 Ω. This conductive glass can be used as the transparent electrode or superstrate for solar cells.

### Embodiment 3

A preparation method for surface-textured conductive glass for solar cells, including the following procedures (As shown in Draw. 6):
(1) An ITO transparent conductive film is coated on a glass substrate by magnetron sputtering, and conductive glass A is derived. The conditions for magnetron sputtering are: base vacuum pressure: 0.9×10⁻⁵ Torr; working pressure: 4 mTorr; working gas: Ar+O₂; sputtering plasma source: direct current or radio frequency 13.56 MHz; power: 800 W; substrate temperature: 100 °C; deposition rate: 80 nm/min;
(2) Prepare a suspension (0.1% w/v) of polystyrene nano-spheres (dia. 1,000 nm) in water, and adjust its pH value to 6; immerse conductive glass A in the suspension for 6 minutes, and then take it out and wash it with water, and then conductive glass B is derived;
   As shown in Draw. 10, conductive glass B is coated with a monolayer of nano-spheres;
(3) Taking nano/micro-spheres as a mask, an ITO transparent conductive film is coated on conductive glass B by magnetron sputtering (the magnetron sputtering conditions are the same as those in Procedure (1)), and thus conductive glass C is derived. The thickness of the film newly coated should not exceed the radius of the nano/micro-spheres, and the total thickness of the transparent conductive film is 1,000 nm;
(4) Remove the nano/micro-spheres deposited on the surface of the transparent conductive film by an ultrasonic vibration method, so as to form the surface texture consisting of U-shaped nano/micro-scopic pits on the surface of conductive glass C, and thus the surface-textured conductive glass for solar cells is derived. The transmittance in the visible spectrum of the conductive glass is 81%, and surface resistance is 2 Ω. This conductive glass can be used as the transparent electrode or superstrate for solar cells.

### Embodiment 4

A preparation method for surface-textured conductive glass for solar cells, including the following procedures (As shown in Draw. 6):
(1) An AZO transparent conductive film is coated on a glass substrate by magnetron sputtering, and conductive glass A is derived. The conditions for magnetron sputtering are: base vacuum pressure: 0.5×10⁻⁵ Torr; working pressure: 6 mTorr; working gas: Ar+O₂; sputtering plasma source: direct current or radio frequency 13.56 MHz; power: 200 W; substrate temperature: 400 °C; deposition rate: 40 nm/min;
(2) Prepare a suspension (0.75% w/v) of polystyrene nano-spheres (dia. 1,000 nm) in water, and adjust its pH value to 3; immerse conductive glass A in the suspension for 8 minutes, and then take it out and wash it with water, and then conductive glass B is derived;
   As shown in Draw. 11, conductive glass B is coated with a monolayer of nano-spheres, the surface area coverage of which is more than 90%;
(3) Taking nano/micro-spheres as a mask, an AZO transparent conductive film is coated on conductive glass B by magnetron sputtering (the magnetron sputtering conditions are the same as those in Procedure (1)), and thus conductive glass C is derived. The thickness of the film newly coated should not exceed the radius of nano/micro-spheres, and the total thickness of the transparent conductive film is 100 nm;
(4) Remove the nano/micro-spheres deposited on the surface of the transparent conductive film by an ultrasonic vibration method, so as to form the surface texture consisting of U-shaped nano/micro-scopic pits on the surface of conductive glass C, and thus the surface-textured conductive glass for solar cells is derived. The transmittance in the visible spectrum of the conductive glass is 84%, and the sheet resistance is 5 Ω. This conductive glass can be used as the transparent electrode or superstrate for solar cells.

### Embodiment 5

A preparation method for surface-textured conductive glass for solar cells, including the following procedures (As shown in Draw. 6):
(1) An AZO transparent conductive film is coated on a glass substrate by magnetron sputtering, and conductive glass A is derived. The conditions for magnetron sputtering are: base vacuum pressure: 0.6×10⁻⁵ Torr; working pressure: 8 mTorr; working gas: Ar+O₂; sputtering plasma source: direct current or radio frequency 13.56 MHz; power: 400 W; substrate temperature: 300 °C; deposition rate: 20 nm/min;
(2) Prepare a suspension (1% w/v) of polystyrene nano-spheres (dia. 1,000 nm) in methanol, and adjust its pH value to 3; immerse conductive glass A in the suspension for 10 minutes, and then take it out and wash it with water, and then conductive glass B is derived;
   As shown in Draw. 12, conductive glass B is coated with a monolayer of nano spheres, the surface area coverage is more than 90%;
(3) Taking nano/micro-spheres as a mask, an AZO transparent conductive film is coated on conductive glass B by magnetron sputtering (the magnetron sputtering conditions are the same as those in Procedure (1)), and thus conductive glass C is derived. The thickness of the film newly coated should not exceed the radius of nano/micro-spheres, and the total thickness of the transparent conductive film is 5,000 nm;
(4) Remove the nano/micro-spheres deposited on the surface of the transparent conductive film by an ultrasonic vibration method, so as to form the surface texture consisting of U-shaped nano/micro-scopic pits on the surface of conductive glass C, and thus the surface-textured conductive glass for solar cells is derived. The transmittance in the visible spectrum of conductive glass is 82%, and the sheet resistance is 3 Ω. This conductive glass can be used as the transparent electrode or superstrate for solar cells.

### Embodiment 6

A preparation method for surface-textured conductive glass for solar cells, including the following procedures (As shown in Draw. 6):
(1) An AZO transparent conductive film is coated on a glass substrate by magnetron sputtering, and conductive glass A is derived. The conditions for magnetron sputtering are: base vacuum pressure: 0.4×10⁻⁵ Torr; working pressure: 2 mTorr; working gas: Ar+O₂; sputtering plasma source: direct current or radio frequency 13.56 MHz; power: 600 W; substrate temperature: 200 °C; deposition rate: 60 nm/min;
(2) Prepare a suspension (0.01% w/v) of polystyrene nano-spheres (dia. 1,000 nm) in methanol, and adjust its pH value to 4; immerse conductive glass A in the suspension for 15 minutes, and then take it out and wash it with water, and then conductive glass B is derived;
   As shown in Draw. 13, conductive glass B is coated with a monolayer of nano-spheres;
(3) Taking nano/micro-spheres as a mask, an AZO transparent conductive film is coated on conductive glass B by magnetron sputtering (the magnetron sputtering conditions are the same as those in Procedure (1)), and thus conductive glass C is derived. The thickness of the film newly coated should not exceed the radius of nano/micro-spheres, and the total thickness of the transparent conductive film is 4,000 nm;
(4) Remove the nano/micro-spheres deposited on the surface of the transparent conductive film by an ultrasonic vibration method, so as to form the surface texture consisting of U-shaped nano/micro-scopic pits on the surface of conductive glass C, and thus the surface-textured conductive glass for solar cells is derived. The transmittance in the visible spectrum of the conductive glass is 82%, and the sheet resistance is 3 Ω. This conductive glass can be used as the transparent electrode or superstrate for solar cells.

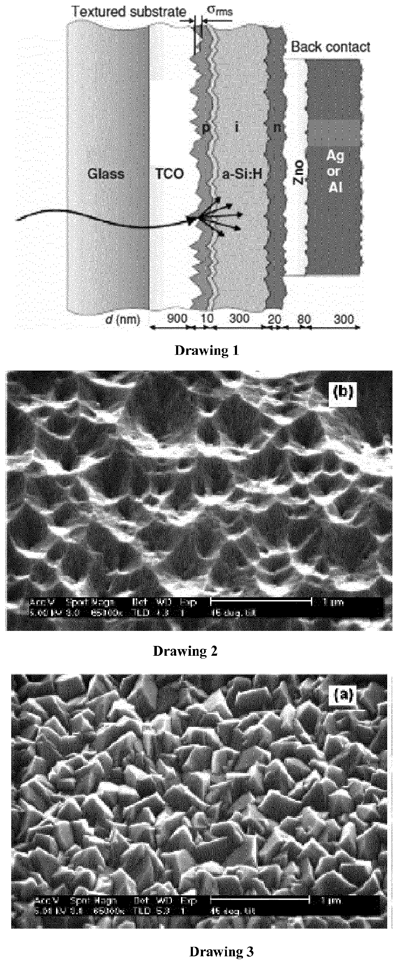

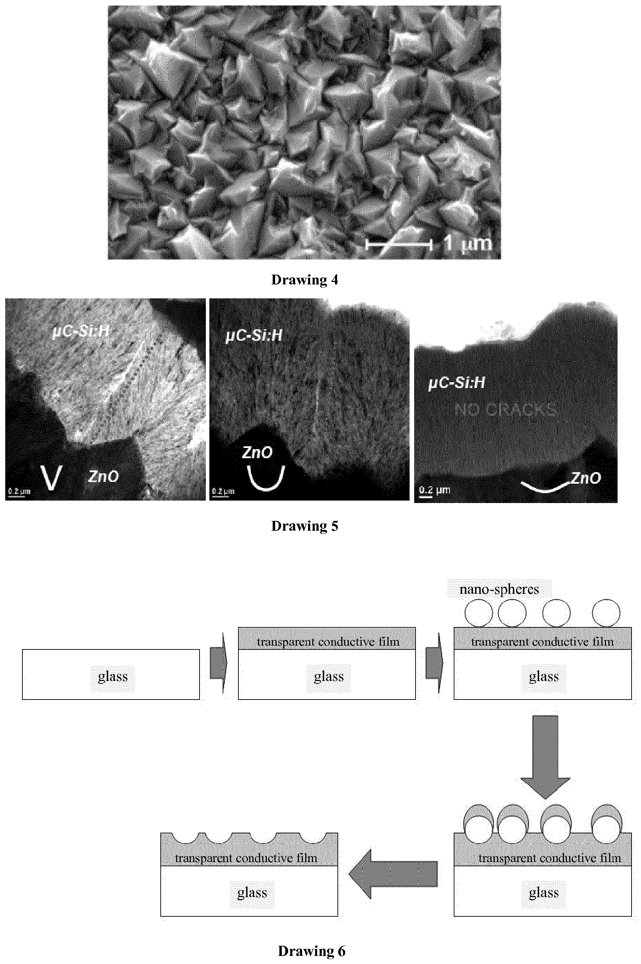

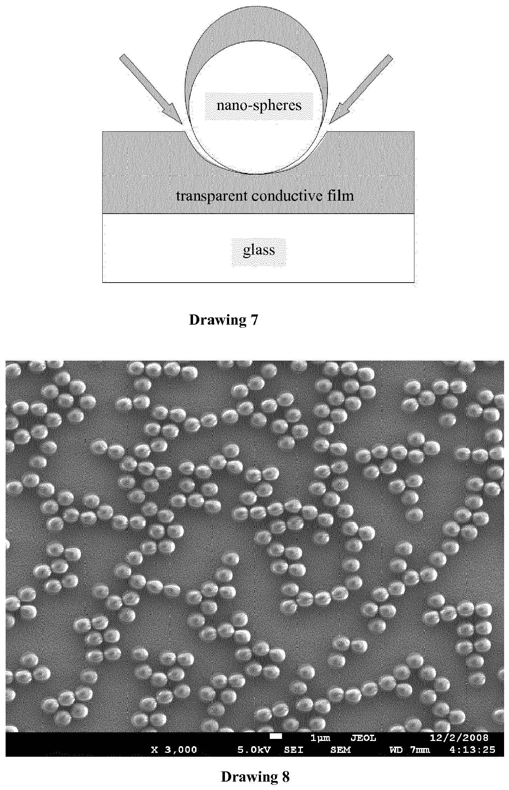

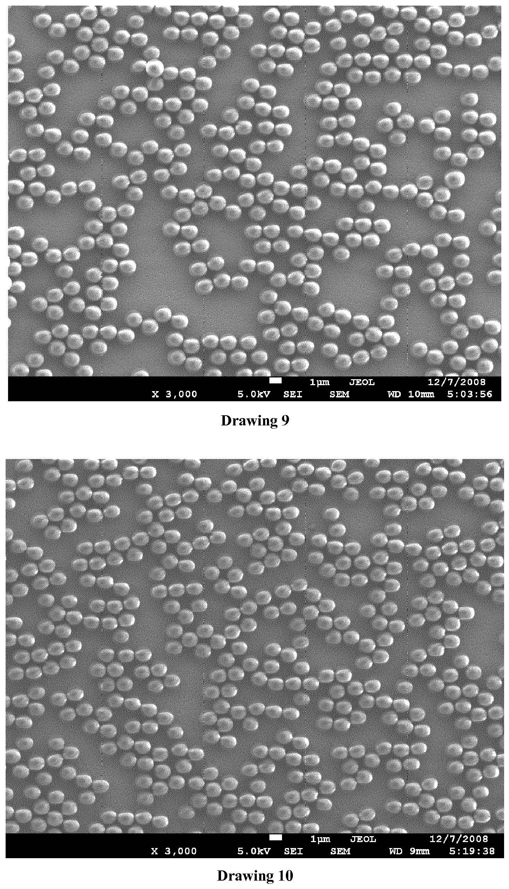

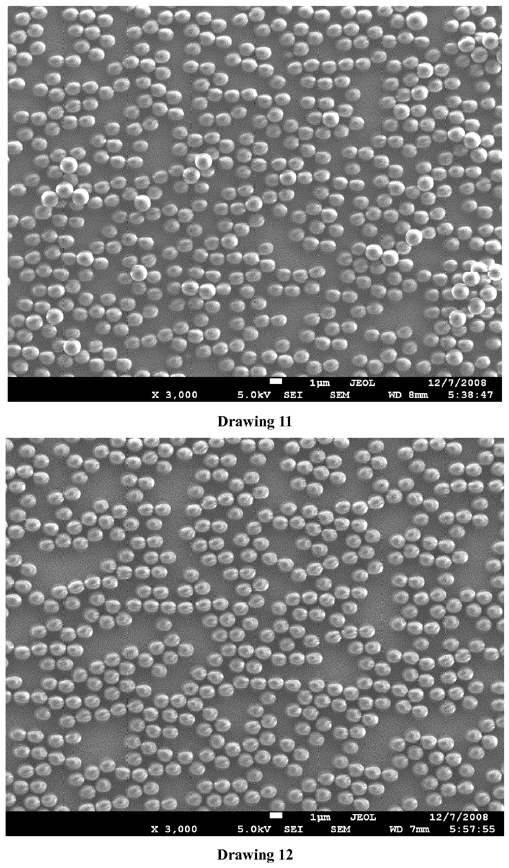

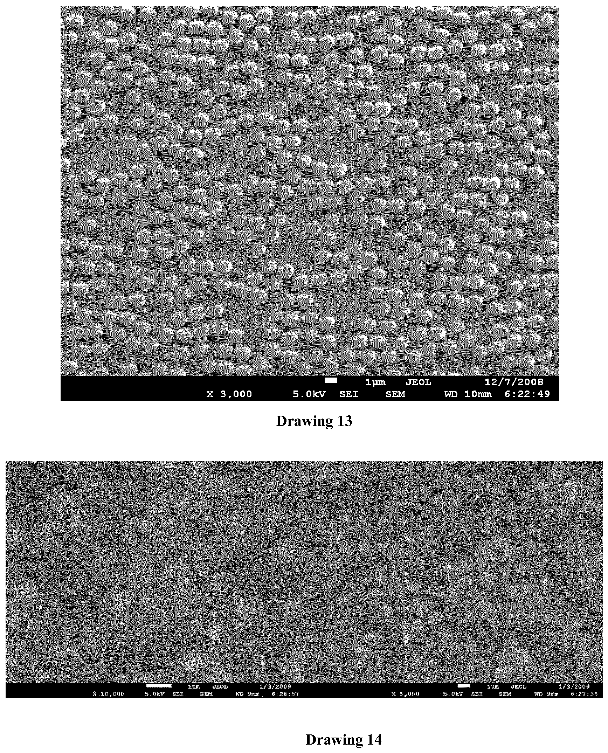

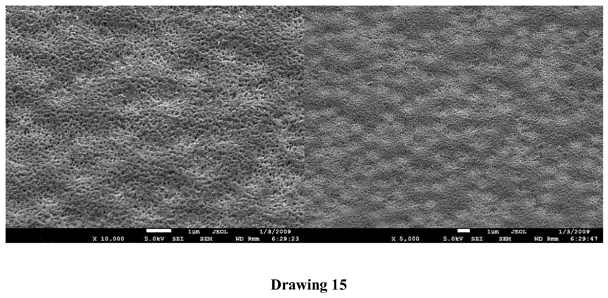

## Claims

1. A preparation method for a surface-textured conductive glass for solar cells, which comprises a transparent conductive film coated on a glass substrate, the upper surface of the transparent conductive film is of a surface texture with nano/micro-scopic U-shaped pits, the preparation method includes the following procedure:
(1) The conductive glass is derived by coating a transparent conductive film on a glass substrate by magnetron sputtering;
wherein the preparation method is **characterized by** the following procedures:
(2) Prepare the suspension of nano/micro-spheres and adjust its pH value to 3-7; immerse the conductive glass of procedure (1) in the suspension for 2-15 minutes, and then take it out and wash it with water;
(3) Taking nano/micro-spheres as a mask, a transparent conductive film is coated on the conductive glass of procedure (2) by magnetron sputtering, wherein the thickness of the film newly coated should not exceed the radius of nano/micro-spheres, and the total thickness of the transparent conductive film is 100-5,000 nm;
(4) Remove the nano/micro-spheres deposited on the surface of the transparent conductive film by an ultrasonic vibration method.

2. The preparation method of the surface-textured conductive glass for solar cells as described in Claim 1 is **characterized in that**: the magnetron sputtering as stated in procedure (1) and (3) is performed under the following conditions: base vacuum pressure: <1×10⁻⁵ Torr; working pressure: 1-10 mTorr; working gas: Ar+O₂; sputtering source: direct current or radio frequency 13.56 MHz; power: 100-1,000 W; substrate temperature: 20-500 °C; deposition rate: 10-100 nm/min.

3. The preparation method of the surface-textured conductive glass for solar cells as described in Claim 1 is **characterized in that**: the diameters of nano/micro-spheres which are stated in procedure (2) are 10 nm-100 µm.

4. The preparation method of the surface-textured conductive glass for solar cells as described in Claim 1 is **characterized in that**: the material of nano/micro-spheres as mentioned in procedure (2) is either silicon dioxide or polystyrene.

5. The preparation method of the surface-textured conductive glass for solar cells as described in Claim 1 is **characterized in that**:
The weight/volume concentration of nano/micro-spheres in the suspension as mentioned in procedure (2) is 0.01-1%;
The solvent of the suspension as mentioned in procedure (2) is either water, methanol or ethanol.

6. The preparation method of the surface-textured conductive glass for solar cells, as mentioned in Claim 1 is **characterized in that**: the immersion time for the conductive glass in the suspension as mentioned in procedure (2) is 8-10 minutes.

## Patentansprüche

1. Verfahren zur Herstellung eines oberflächentexturierten leitfähigen Glases für Solarzellen, das einen transparenten leitfähigen Film auf ein Glassubstrat geschichtet umfasst, wobei die obere Oberfläche des transparenten leitfähigen Films eine Oberflächentextur mit nano/mikroskopischen U-Förmigen Gruben aufweist, wobei das Herstellungsverfahren folgende Arbeitsschritte umfasst:
(1) das leitfähige Glas wird durch Schichten eines transparenten leitfähigen Films auf ein Glassubstrat durch Magnetron-Sputtering erhalten;
wobei das Herstellungsverfahren folgende Arbeitsschritte gekennzeichnet ist:
(2) Herstellen einer Suspension von Nano/Mikrokügelchen und Einstellen ihres pH-Werts auf 3-7; Eintauchen des leitfähigen Glases von Arbeitsschritt (1) in die Suspension für 2-15 Minuten und Entnehmen und Waschen davon mit Wasser;
(3) ein transparenter leitfähiger Film wird durch Magnetron-Sputtering auf das leitfähige Glas von Arbeitsschritt (2) geschichtet, wobei Nano/Mikrokügelchen als Maske genommen werden, wobei die Dicke des neu aufgeschichteten Films den Radius der Nano/Mikrokügelchen nicht übersteigen sollte und die Gesamtdicke des transparenten leitfähigen Films 100-5.000 nm beträgt;
(4) Entfernen der auf der Oberfläche des transparenten leitfähigen Films aufgebrachten Nano/Mikrokügelchen durch ein Ultraschallschwingungsverfahren.

2. Verfahren zur Herstellung des oberflächentexturierten leitfähigen Glases für Solarzellen gemäß Anspruch 1, **dadurch gekennzeichnet, dass**: das bei Arbeitsschritt (1) und (3) genannte Magnetron-Sputtering unter folgenden Bedingungen durchgeführt wird: Grundvakuumdruck: < 1 x 10⁻⁵ Torr; Arbeitsdruck: 1-10 mTorr; Arbeitsgas: Ar + O₂; Sputteringquelle: Gleichstrom oder Radiofrequenz 13,56 MHz; Leistung: 100-1.000 W; Substrattemperatur: 20-500 °C; Abscheidungsrate: 10-100 mm/min.

3. Verfahren zur Herstellung des oberflächentexturierten leitfähigen Glases für Solarzellen gemäß Anspruch 1, **dadurch gekennzeichnet, dass**: die Durchmesser der bei Arbeitsschritt (2) genannten Nano/Mikrokügelchen 10 nm bis 100 µm betragen.

4. Verfahren zur Herstellung des oberflächentexturierten leitfähigen Glases für Solarzellen gemäß Anspruch 1, **dadurch gekennzeichnet, dass**: das Material der bei Arbeitsschritt (2) genannten Nano/Mikrokügelchen entweder Siliciumdioxid oder Polystyrol ist.

5. Verfahren zur Herstellung des oberflächentexturierten leitfähigen Glases für Solarzellen gemäß Anspruch 1, **dadurch gekennzeichnet, dass**:
die Gewicht/Volumen-Konzentration der Nano/Mikrokügelchen in der bei Arbeitsschritt (2) genannten Suspension 0,01-1 % beträgt;
das Lösungsmittel der bei Arbeitsschritt (2) genannten Suspension Wasser, Methanol oder Ethanol ist.

6. Verfahren zur Herstellung des oberflächentexturierten leitfähigen Glases für Solarzellen gemäß Anspruch 1, **dadurch gekennzeichnet, dass**: die Eintauchzeit des leitfähigen Glases in der bei Arbeitsschritt (2) genannten Suspension 8-10 Minuten beträgt.

## Revendications

1. Procédé de préparation pour un verre conducteur à surface texturée destiné à des batteries solaires, qui comprend un film conducteur transparent revêtu sur un substrat de verre, la surface supérieure du film conducteur transparent étant composée d'une texture de surface présentant des creux nano/microscopiques en forme de U, le procédé de préparation comportant la procédure suivante :
(1) le verre conducteur est obtenu en revêtant un film conducteur transparent sur un substrat de verre par pulvérisation magnétron ;
le procédé de préparation étant **caractérisé par** les procédures suivantes :
(2) préparer la suspension de nano/microsphères et ajuster sa valeur de pH de 3 à 7 ; immerger le verre conducteur de la procédure (1) dans la suspension pendant 2 à 15 minutes et ensuite le sortir et le laver avec de l'eau ;
(3) en prenant les nano/microsphères tel un masque, un film conducteur transparent est revêtu sur le verre conducteur de la procédure (2) par pulvérisation magnétron, l'épaisseur du film nouvellement revêtu ne devant pas être supérieure au rayon des nano/microsphères et l'épaisseur totale du film conducteur transparent étant de 100 à 5000 nm ;
(4) éliminer les nano/microsphères déposées sur la surface du film conducteur transparent par un procédé de vibration ultrasonique.

2. Procédé de préparation du verre conducteur à surface texturée destiné à des batteries solaires tel que décrit selon la revendication 1, **caractérisé en ce que** : la pulvérisation magnétron telle qu'indiquée dans la procédure (1) et (3) est effectuée dans les conditions suivantes : pression du vide de base : <1x10⁻⁵ Torr ; pression de travail : 1 à 10 mTorr ; gaz de travail : Ar + O₂ ; source de pulvérisation: courant direct ou radiofréquence 13,56 MHz; puissance : 100 à 1000 W ; température du substrat : 20 à 500°C ; vitesse de déposition : 10-100 nm/min.

3. Procédé de préparation du verre conducteur à surface texturée destiné à des batteries solaires tel que décrit selon la revendication 1, **caractérisé en ce que** : les diamètres des nano/microsphères qui sont indiquées dans la procédure (2) sont de 10 nm à 100 µm.

4. Procédé de préparation du verre conducteur à surface texturée destiné à des batteries solaires tel que décrit selon la revendication 1, **caractérisé en ce que** : le matériau des nano/microsphères telles que mentionnées dans la procédure (2) est soit le dioxyde de silicium soit le polystyrène.

5. Procédé de préparation du verre conducteur à surface texturée destiné à des batteries solaires tel que décrit selon la revendication 1, **caractérisé en ce que** :
la concentration poids/volume des nano/microsphères dans la suspension telle que mentionnée dans la procédure (2) est de 0,01 à 1% ;
le solvant de la suspension telle que mentionnée dans la procédure (2) est soit l'eau, soit le méthanol, soit l'éthanol.

6. Procédé de préparation du verre conducteur à surface texturée destiné à des batteries solaires tel que décrit selon la revendication 1, **caractérisé en ce que** : le temps d'immersion pour le verre conducteur dans la suspension telle que mentionnée dans la procédure (2) est de 8 à 10 minutes.
